# EUROPEAN PATENT APPLICATION

(11) **EP 4 576 174 A1**
(43) Date of publication of application: **25.06.2025**
(21) Application number: 23218693.2
(22) Date of filing: 20.12.2023
(51) Int. Cl.: H01L 21/48, H01L 23/13, H01L 23/31, H01L 23/498, H01L 23/538

(54) **ELECTRONIC COMPONENT**

(71) Applicant: Murata Manufacturing Co., Ltd., Nagaokakyo-shi, Kyoto 617-8555 (JP)
(72) Inventor: KAIJA, Kimmo, 02660 Espoo (FI)
(74) Representative: Boco IP Oy Ab

(57) **Abstract**

An electronic component comprising a substrate and a packaging layer on a first side of the substrate. The component also comprises at least one vertical electrical conductor embedded in a layer of elastic material, so that the layer of elastic material lies between the at least one vertical electrical conductor and the packaging layer.

## Description

### FIELD OF THE DISCLOSURE

The present disclosure relates to electronic components, and particularly to the reliability of the electric connections between a component and the circuit board where the component is mounted.

### BACKGROUND OF THE DISCLOSURE

Electronic components typically contain a semiconductor chip which is mounted on a supporting surface and then protected with a package which encapsulates the sensitive chip and shields it from the surrounding environment. The package forms a part of the component. Electrical conductors which extend from the chip to the outside of the package connect the chip to the outside world. When the electronic component is mounted on a circuit board, the outer end of these electrical conductors is typically connected to conductors on the circuit board. The electrical circuit on the circuit board can thereby interact with the chip inside the electronic component.

Electronic components are often mounted and electrically connected to circuit boards with mechanically rigid connections. The connection may for example be solder connection which solidifies after the desired electrical connection has been made. A general problem with such connections is that they may be damaged by thermal stress. The circuit board may for example undergo heat expansion. If the electronic component expands less than the circuit board, the rigid electrical connections between the circuit board and an electronic component mounted on the circuit board may crack.

Document US20160113127 discloses an electronic module where a laminated sequence of layers forms the lower part of a package and provides flexibility to the module. However, this requires a complex manufacturing process with many consecutive lamination steps.

### BRIEF DESCRIPTION OF THE DISCLOSURE

An object of the present disclosure is to provide an electronic component which avoids the disadvantage indicated above.

The object of the disclosure is achieved by an electronic component characterized by what is stated in the independent claims. Some embodiments of the disclosure are disclosed in the dependent claims.

The disclosure is based on the idea of utilizing vertical conductors embedded in an elastic material. An advantage of this solution is that flexibility is achieved with a simple structure.

### BRIEF DESCRIPTION OF THE DRAWINGS

In the following the disclosure will be described in greater detail by means of preferred embodiments with reference to the accompanying drawings, in which:
Figure 1 illustrates an electronic component.
Figure 2 illustrates an electronic component under thermal stress.
Figures 3a - 3b illustrate optional arrangements for accommodating thermal stress.
Figures 4a - 4c illustrate xy-cross sections of electronic components.
Figures 5, 6 and 7a - 7b illustrate manufacturing methods.

### DETAILED DESCRIPTION OF THE DISCLOSURE

This disclosure describes an electronic component which comprises a substrate which defines a horizontal xy-plane and a vertical z-direction which is perpendicular to the xy-plane. The electronic component comprises at least one conductor region and at least one chip region in the xy-plane. The substrate has a first side and a second side.

The electronic component also comprises one or more chips attached to the one or more chip regions on the substrate. The electronic component also comprises a packaging layer which has a first side and a second side. The second side of the packaging layer is attached to the first side of the substrate. The packaging layer comprises one or more cavities in the at least one conductor region. The one or more cavities extend from the first side of the packaging layer to the second side of the packaging layer. The component comprises one or more vertical electrical conductors which are attached to the first side of the substrate in the at least one conductor region. The one or more vertical electrical conductors extend through the one or more cavities in the vertical direction.

The first and second sides of the substrate are opposite to each other in the z-direction. The first and second sides of the packaging layer are opposite to each other in the z-direction.

The at least one vertical electrical conductor may be in electrical contact with the one or more chips. The at least one vertical electrical conductor may thereby form a part of a signal connection between the one or more chips and an external circuit. The at least one vertical electrical conductor may be partly exposed on the bottom of the electronic component, so that it can be connected to an external circuit, for example when the electronic component mounted on an external circuit board.

The term "horizontal" refers in this disclosure to directions which are parallel to the xy-plane. The term "vertical" refers to a direction which is perpendicular to the xy-plane. These terms do not refer to the direction of the Earth's gravity. In other words, the electronic component may be oriented in any direction when the component is used or when it is manufactured, and the vertical direction does not necessarily coincide with the direction of gravitational force (though they may coincide). These considerations apply also to terms such as "top" and "bottom".

Even though some parts of the electronic component are described as "vertical" parts in this disclosure, that does not mean that they must always necessarily be perfectly vertical. Instead, in this context the term vertical simply means that these parts extend in the general direction of the z-axis without any turns in the horizontal direction.

Each of the one or more vertical electrical conductors may be embedded in a layer of elastic material, so that the layer of elastic material fills the corresponding cavity and lies between the vertical electrical conductor and the packaging layer in the horizontal direction.

The layer of elastic material may also be called a buffer, or a buffer layer. The substrate may also be called an interposer.

Alternatively, each of the one or more cavities may be filled with a gas, so that each of the one or more vertical electrical conductors is surrounded by the gas in the corresponding cavity. The gas may have low pressure, and in some embodiments the one or more cavities may be filled with vacuum. These options will be discussed in more detail below.

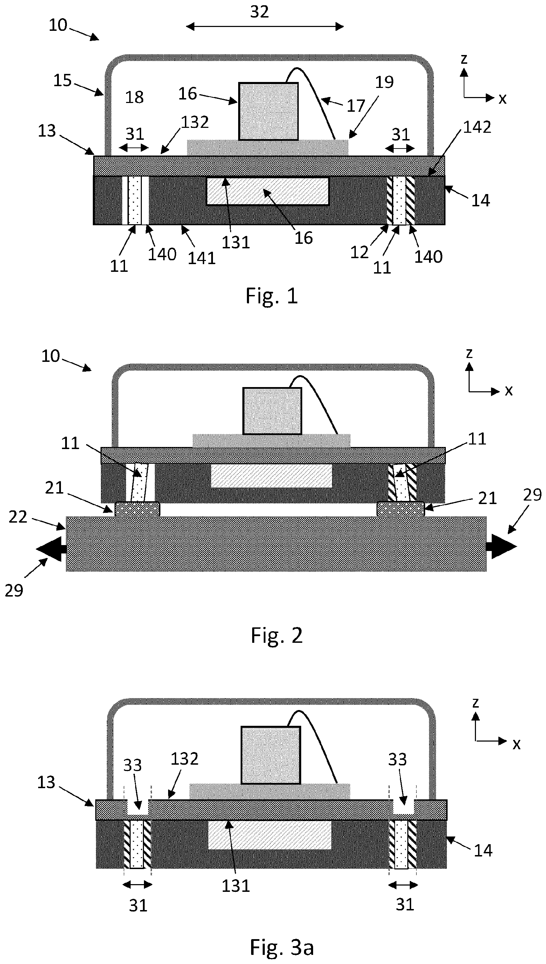

Figure 1 illustrates an electronic component 10 which comprises a substrate 13. The electronic component 10 comprises conductor regions 31 and chip regions 32. The number of conductor regions and chip regions can be freely selected. The substrate has a first side 131, which may also be called a first surface. The first side 131 is illustrated as the bottom side of the substrate 13 in figure 1. The substrate also has a second side 132, which may be called a second surface. The second side 132 is illustrated as the top side of the substrate 13 in figure 1.

The substrate 13 may for example be a circuit board. It may for example be a ceramic substrate, or a substrate made of FR4. The substrate may comprise conductive vias which provide electrical connections between the first and second sides of the substrate.

The electronic component 10 comprises one or more chips 16 attached to the substrate 13 in the one or more chip regions 31. These chips 16 may be attached to the first side 131 of the substrate and/or to the second side 132 of the substrate, as figure 1 illustrates. The chips 16 may also be called electronic chips or dies. The chips 16 may for example be MEMS chips, or ASIC (application-specific integrated circuit) chips.

The one or more chips 16 do not necessarily have to be mounted directly on the substrate. The electronic component may comprise a chip-mounting surface 19 which is attached to the substrate 13. Some or all of the one or more chips 16 may be mounted on the chip-mounting surface 19. Electrical wires 17 may connect the chips 16 electrically to a circuit in and on the substrate 13.

The electronic component 10 also comprises a packaging layer 14. The first side 141 of the packaging layer 14 may form the bottom of the electronic component 10, as figure 1 illustrates. The second side 142 of the packaging layer may be attached to the bottom of the substrate 13, as figure 1 illustrates.

The packaging layer may comprise a mouldable material. This material may for example be plastic, or it may be a thermoplastic polymer or thermoplastic elastomer. The packaging layer 14 may for example be injection-moulded onto the first surface 131 of the substrate 13. All chips on this side of the substrate may thereby be embedded in the packaging layer 14. Alternatively, the packaging layer may for example be manufactured by transfer molding, compression molding, potting or casting. Other options are also possible. The packaging layer may be a rigid layer which protects the one or more dies 16 and the substrate from the external environment.

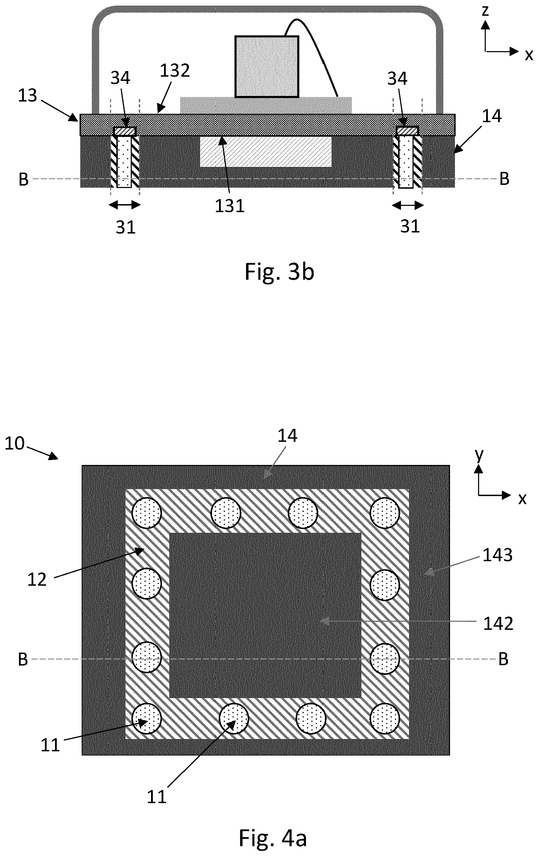

The packaging layer 14 comprises one or more cavities 140. Each cavity is located below the substrate 13 in a conductor region 31. The two areas 140 in figure 1 could form a single cavity or multiple cavities, as figures 4a - 4c illustrate. The cavity 140 on the left is illustrated as an open cavity which is filled with a gas. The cavity 140 on the right is illustrated as a cavity filled with an elastic material 12.

The component 10 also comprises one or more vertical electrical conductors 11. These conductors 11 are located in the conductor regions 31. They extend in the vertical direction from the first side 131 of the substrate 13 (and the second side 142 of the packaging layer 14) through the cavity 140 in the packaging layer 14 to the first side 141 of the packaging layer 14. The one or more vertical electrical conductors 11 may be exposed on the first side 141 of the packaging layer 14. When the electronic component 10 is mounted onto an external circuit board 22, as in figure 2, the conductors 11 may be electrically connected to corresponding contacts 21 on the surface of the external circuit board 22.

The at least one vertical electrical conductor 11 may be embedded in a layer 12 of elastic material, as figure 1 illustrates. The layer 12 of elastic material may surround the vertical electrical conductor 11 in all directions which are parallel to the xy-plane. The layer 12 may have the same height in the z-direction as the vertical electrical conductor 11.

If the one or more cavities 140 comprise multiple cavities, then some cavities may be filled with the gas and other cavities may be filled with the elastic material. Alternatively, all cavities may be filled with the gas. Alternatively, all cavities may be filled with the elastic material 12. The gas may be air. The layer of elastic material may for example be silicone, parylene, a gel or acryl. The material which is used in the layer 12 should be significantly more elastic than the material of the packaging layer 14.

The electronic component may optionally comprise a cap 15 on the second side 132 of the substrate 13. The cap 15 may cover any chips 16 which have been mounted on the second side 132 of the substrate 13. The cap 15 may form an enclosure 18 where the chips 16 are located. The enclosure 18 may be filled with a gas such as air or with a gel.

The cap 15 may be made of metal. However, the cap could alternatively comprise a mouldable material, for example plastic. In the latter case, the cap may be injection-moulded onto the second surface 132 of the substrate 13 so that all chips 16 on this side of the substrate are embedded in the cap (this option has not been illustrated). The cap may be made of the same material as the packaging layer.

Other forms of encapsulation are also possible. Furthermore, the electronic component 10 does not necessarily have to contain any chips 16, or any encapsulation, or anything else, on the second surface 132 of the substrate 13.

The electronic component may comprise a land grid array (LGA) package or ball grid array (BGA) package. Either array package may comprise at least the packaging layer 14 and the conductor 11.

The at least one vertical electrical conductor 11 may be a post or a pin, for example made of metal. The at least one vertical electrical conductor may be straight, i.e. it may have a linear shape. It may have a cylindrical shape. The widths of the at least one vertical electrical conductor 11 in the x- and y-directions may, but does not necessarily have to, be less than its height in the z-direction. The vertical electrical conductor 11 may be a block of metal which is manufactured separately and then placed onto the first side 131 of the substrate 13 before the packaging layer 14 is formed. The material of the vertical electrical conductor 11 may for example be copper.

Figure 2 illustrates a situation where the electronic component of figure 1 has been mounted onto an external circuit board 22. The word "external" refers to here to a circuit board which is not itself a part of the electronic component 10. Instead, the electronic component 10 is mounted onto the external circuit board 22 when it is used. The contacts 21 which connect the vertical electrical conductors 11 to circuitry (not illustrated) on the external circuit board 22 may for example be solder joints.

The external circuit board 22 in figure 2 undergoes thermal expansion (illustrated with arrows 29). If this expansion is greater than the thermal expansion of the electronic component 10, there is a possibility that the contacts may be damaged. However, when the vertical electrical conductors 11 are embedded in the layer 12, or otherwise free to move in the cavity, they can undergo movement inside packaging layer 14 to accommodate the thermal expansion and reduce the risk of damage. This movement is illustrated as a slight tilt in the vertical electrical conductors 11 in figure 2. The movement allows the electrical contact between the vertical electrical conductors 11 and the contacts 21 to be maintained even if the electronic component 10 and the external circuit board 22 undergo different amounts of thermal expansion.

Figure 2 illustrates a rigid vertical electrical conductor 11 which maintains its shape even when thermal stress expands the external circuit board 22. The movement is therefore a tilting movement. However, the vertical electrical conductor 11 could alternatively be dimensioned so that it has some degree of flexibility and the x-direction and/or in the y-direction. The movement of the vertical electrical conductor under thermal stress could then be bending instead of tilting. This option has not been illustrated. The dimensions needed to facilitate bending depend on the material and the dimensions of the vertical electrical conductor 11 and on the forces which are expected to act on the vertical electrical conductor 11 in thermal stress.

Figure 3a illustrates an embodiment where the thickness of the substrate 13 in the z-direction is less in the one or more conductor regions 31 than the thickness of the substrate the z-direction in the one or more chip regions 32. In other words, the substrate 13 may comprise a recessed area 33 in each conductor region 31. This embodiment may be combined with any other embodiment presented in this disclosure.

Figure 3b illustrates an embodiment where the substrate 13 comprises a flexible pad 34 in each of the one or more conductor regions 31. The flexible pad 34 may for example be a polymer film, or any other suitably flexible film. The film may be laminated or deposited onto the first surface 131 of the substrate 13. The vertical electrical conductor may then be attached to the flexible pad 34. This embodiment may be combined with any other embodiment presented in this disclosure, including the one shown in figure 3a.

The embodiments shown in figures 3a and 3b may be implemented, together or separately, to accommodate the tilting (or bending) of the vertical electrical conductor 11 illustrated in figure 2. The electrical contact between the substrate 13 and the vertical electrical conductor 11 can then be maintained despite the movement. However, this electrical contact may in some cases be maintained even if neither of the two solutions shown in figures 3a and 3b is implemented. The sensitivity of the electrical contact between the substrate 13 and the vertical electrical conductor 11 depends on how they have been attached to each other. Some forms of attachment may accommodate the tilting / bending sufficiently regardless of how the substrate 13 is constructed in the conductor regions 31.

Figures 3a and 3b illustrate recessed areas 33 and flexible pads 34 over cavities that are filled with elastic material, but they may also be implemented over gas-filled cavities.

The one or more cavities may comprise a single cavity, and the one or more vertical electrical conductors may comprise a first vertical electrical conductor and a second vertical electrical conductor. The first and second vertical electrical conductors may be in the single cavity, so that the single cavity extends from the first vertical electrical conductor to the second vertical electrical conductor. This option can be implemented together with any embodiment shown in figures 1 - 3b.

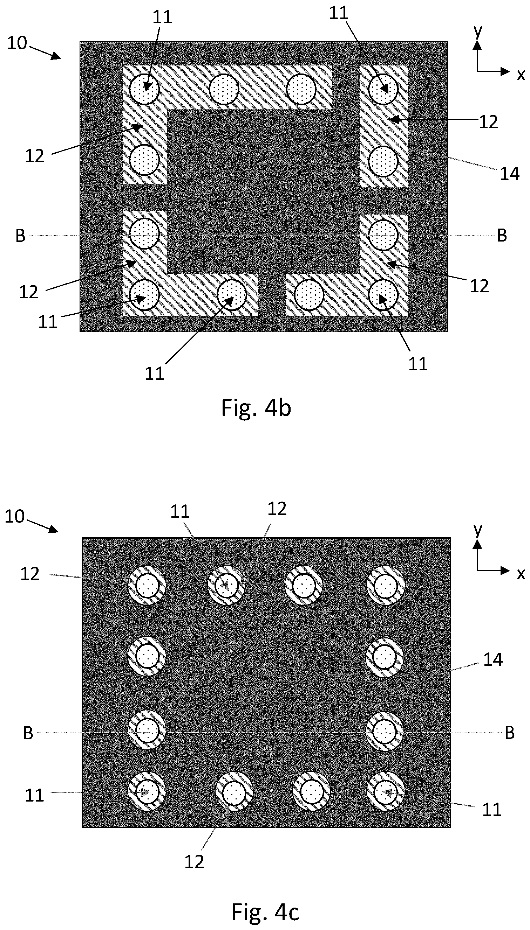

Figure 4a illustrates an xy-cross section of an electrical component. This cross-section, and any of the cross-sections shown in figures 4b - 4c, may for example lie at the z-coordinate of the B-B line in figure 3b (or the corresponding z-coordinate in any of figures 1 - 3a). The xz-cross-sections in figures 1 - 3b may correspondingly lie at the y-coordinate indicated by the B-B line in any of figures 4a - 4c.

The component 10 in figure 4a comprises multiple vertical electrical conductors 11 arranged in a rectangular pattern in the xy-plane. Any other pattern could also be used. The layer of elastic material 12 lies between each vertical electrical conductor 11 and the packaging layer 14 in the horizontal direction. The layer of elastic material 12 extends from each vertical electrical conductor 11 to the adjacent vertical electrical conductor 11. In other words, the vertical electrical conductors 11 are here embedded in the same layer of elastic material 12. The cavity could alternatively be filled with a gas. This option has not been separately illustrated.

In figure 4a the packaging layer 14 comprises a central region 143 and a peripheral region 144. The single cavity surrounds the central region 143 of the packaging layer 14 in the horizontal direction. The peripheral region 144 of the packaging layer 14 surrounds the single cavity in the horizontal direction. In other words, the layer of elastic material 12 surrounds the central region 143, and the peripheral region 144 surrounds the layer of elastic material 12-As figure 4a illustrates, the one or more vertical electrical conductors may comprise more than two vertical electrical conductors 11, and the layer of elastic material 12 may form a continuous elastic body which surrounds all of these vertical electrical conductors 11. In other words, all vertical electrical conductors 11 may be embedded in the same layer of elastic material 12. All vertical electrical conductors 11 may therefore also be in the same cavity. Other options are also possible. A layer of elastic material 12 may for example extend from a first vertical electrical conductor to a second vertical electrical conductor without extending to all vertical electrical conductors. This has been illustrated in figure 4b, where the electrical component 10 again comprises more than two vertical electrical conductors 11. These vertical electrical conductors 11 are divided into groups of two, three and four. A layer of elastic material 12 extends between the vertical electrical conductors 11 in each group, but all vertical electrical conductors 11 are not embedded in the same layer. The placement pattern shown in figure 4b is only one example. The vertical electrical conductors 11 could alternatively be arranged in any other pattern in the xy-plane. The divisions between the different groups of vertical electrical conductors 11, the position pattern of each group, and the number of vertical electrical conductors 11 in each group can be selected in any suitable manner.

Figure 4c a component 10 which comprises multiple vertical electrical conductors 11. A layer of elastic material 12 lies between each vertical electrical conductor 11 and the packaging layer 14 in the horizontal direction. But in this case a separate layer of elastic material 12 surrounds each vertical electrical conductor 12. In other words, no pair of vertical electrical conductors 11 is embedded in the same layer of elastic material 12. The vertical electrical conductors in figure 4c could be placed in the xy-plane in any suitable pattern. The layers of elastic material 12 are illustrated as rings that surround the corresponding vertical electrical conductor 11 in figure 4c. These layers could instead have a rectangular shape or any other shape in the xy-plane.

More generally, the electrical component may comprise more than one cavity and more than one vertical electrical conductors 11. The vertical electrical conductors 11 may be divided between the cavities so that they are not all in the same cavity. There may still be multiple vertical electrical conductors 11 in the same cavity, as figure 4b illustrates. Alternatively, each vertical electrical conductor 11 may be in its own cavity, as figure 4c illustrates. The cavities illustrated in figures 4b and 4c could alternatively be filled with a gas.

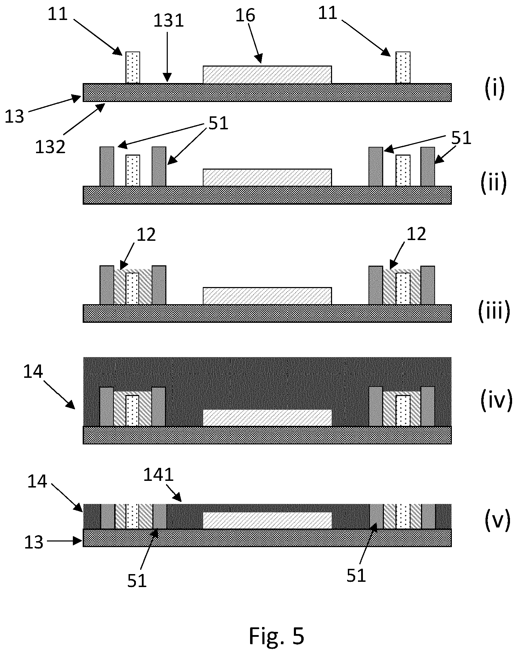

Figure 5 illustrates a manufacturing method which may be used to manufacture any electronic component illustrated in figures 1 - 4c when the cavity is filled with an elastic material 12. This figure only illustrates the manufacturing which takes place on the first side 131 of a substrate 13. Other steps may optionally be performed on the second side 132 of the substrate either before or after the steps illustrated in figure 5.

Step (i) in figure 5 shows vertical electrical conductors 11 which have been placed on the substrate 13 in an upright position. One or more chips 16 may optionally also be placed on the substrate 13. In step (ii) one or more dam structures 51 are formed on the first side 131 of the substrate 13. Each dam structure 51 may surround one or more vertical electrical conductors 11. In step (iii) the elastic material is dispensed into inside each dam structure 51, so that each vertical electrical conductor 11 is surrounded by a layer of elastic material 12.

In other words, the layer of elastic material may be surrounded by a dam structure in the horizontal direction, so that the dam structure extends from the layer of elastic material to the packaging layer.

The dam structure 51 may for example be made of epoxy or acryl. The dam structure may for example comprise an inner wall and an outer wall, and all of the vertical electrical conductors 11 may lie between the inner wall and the outer wall. This produces an arrangement similar to figure 4a.

Alternatively, multiple dam structures surrounding one or more vertical electrical conductors may be built, producing an arrangement similar to figures 4b or 4c. In either case, the dam structures 51 between the layer of elastic material 12 and the packaging layer 14. This is illustrated in steps (iv) and (v), where (iv) the packaging layer 14 is formed on the first side 131 of the substrate 13, for example by injection moulding. Then a grinding process is performed (v) to expose the vertical electrical conductors on the first side 141 of the packaging layer 14. The dam structures 51 remain in the finished component.

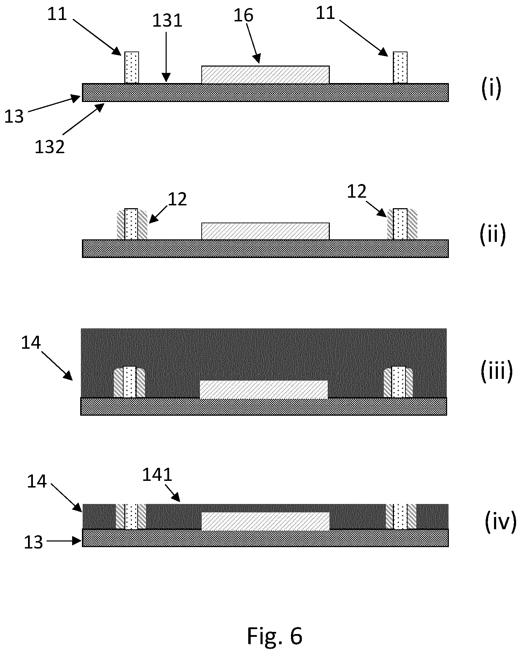

Figure 6 illustrates an alternative manufacturing method which may be used to manufacture any electronic component illustrated in figures 1 - 3b and 4c when it is filled with an elastic material. Again, this figure only illustrates the manufacturing which takes place on the first side 131 of a substrate 13. Other steps may optionally be performed on the second side 132 of the substrate either before or after the steps illustrated in figure 6. Step (i) in figure 6 is the same as step (i) in figure 5. In step (ii) a layer of elastic material 12 is dispensed onto each vertical electrical conductor 11 and cured. Alternatively, the vertical electrical conductors 11 may already comprise a pre-existing layer of elastic material 12 when they are placed onto the substrate 13.

Steps (iii) and (iv) in figure 6 correspond to (iv) and (v) in figure 5. The packaging layer 14 may for example (iii) be overmolded on the first side 131 of the substrate 13, and then cured. The ends of the vertical electrical conductors 11 may then be exposed (iv) by grinding or polishing the packaging layer 14.

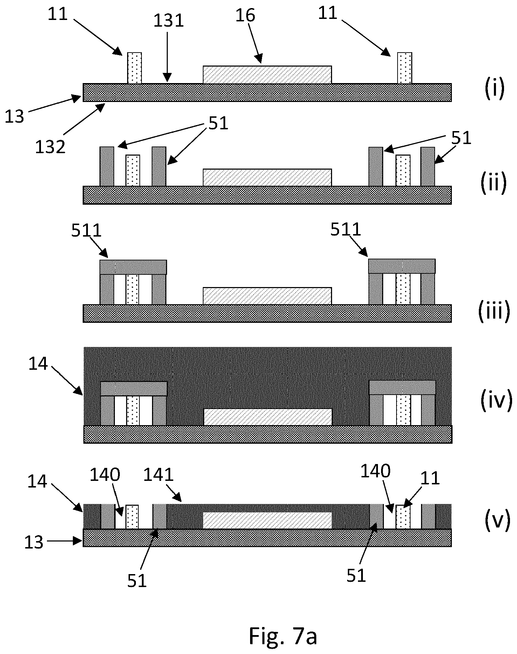

Figure 7a illustrates a first manufacturing method which may be used to manufacture any electronic component illustrated in figures 1 - 4c when the cavity is filled with a gas. Steps (i) and (ii) are the same as in figure 5. In step (iii) the dam structure also comprises a cover 511 which covers the top of each vertical electrical conductor 11. The cavity 140 is therefore not filled with any material in step (iv), and the subsequent grinding in step (v) leaves a cavity 140 filled with gas.

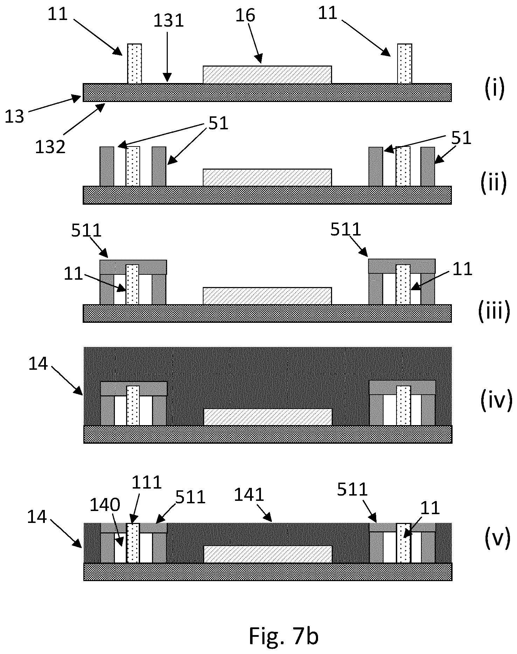

Figure 7b illustrates a second manufacturing method which may be used to manufacture any electronic component illustrated in figures 1 - 4c when the cavity is filled with a gas. Steps (i) and (ii) are the same as in figure 5. In step (iii) the dam structure is extended over and across the cavity with a cover 511, as in figure 7b. However, here the vertical electrical conductors 11 are partly embedded in the cover 511. In step (iv) the cavity 140 is not filled with the material which forms the packaging layer 14. The grinding process in step (v) is then performed only to a depth where the tips of 111 the vertical electrical conductors 11 are exposed on the first side 141 of the packaging layer. In this case the cover 511 remains in the finished component and delimits the cavity 140.

All options mentioned above with reference to figure 5 which are not related to the elastic material 12 are available in figures 7a and 7b also.

## Claims

1. An electronic component comprising:
- a substrate which defines a horizontal xy-plane and a vertical z-direction which is perpendicular to the xy-plane, wherein the substrate has a second side and a first side,
- at least one conductor region and at least one chip region in the xy-plane,
- one or more chips attached to the at least one chip region on the substrate,
- a packaging layer which has a second side and a first side, wherein the second side of the packaging layer is attached to the first side of the substrate,
**characterized in that** the packaging layer comprises one or more cavities in the at least one conductor region, and the one or more cavities extend from the first side of the packaging layer to the second side of the packaging layer, and the component comprises one or more vertical electrical conductors which are attached to the first side of the substrate in the at least one conductor region and extend through the one or more cavities in the vertical direction.

2. An electronic component according to claim 1, wherein each of the one or more vertical electrical conductors is embedded in a layer of elastic material, so that the layer of elastic material fills the corresponding cavity and lies between the vertical electrical conductor and the packaging layer in the horizontal direction.

3. An electronic component according to claim 2, wherein the elastic material is silicone.

4. An electronic component according to claim 1, wherein each of the one or more cavities is filled with a gas, so that each of the one or more vertical electrical conductors is surrounded by the gas in the corresponding cavity.

5. An electronic component according to any of claims 1-4, wherein the one or more cavities comprise a single cavity, the one or more vertical electrical conductors comprise a first vertical electrical conductor and a second vertical electrical conductor, and the first and second vertical electrical conductors are in the single cavity, so that the single cavity extends from the first vertical electrical conductor to the second vertical electrical conductor.

6. An electronic component according to claim 5, wherein the packaging layer comprises a central region and a peripheral region, and the single cavity surrounds the central region of the packaging layer in the horizontal direction, and the peripheral region of the packaging layer surrounds the single cavity in the horizontal direction.

7. An electronic component according to any preceding claim, wherein the thickness of the substrate in the z-direction is less in the one or more conductor regions than the thickness of the substrate the z-direction in the one or more chip regions.

8. An electronic component according to any preceding claim, wherein the substrate comprises a flexible pad in each of the one or more conductor regions.

9. An electronic component according to any preceding claim, wherein each of the one or more cavities is surrounded by a dam structure in the horizontal direction, so that the dam structure extends from said cavity to the packaging layer.

10. An electronic component according to any preceding claim, wherein the one or more vertical electrical conductors are metal posts.

11. An electronic component according to any preceding claim, wherein the one or more vertical electrical conductors are made of copper.

12. An electronic component according to any preceding claim, wherein the packaging layer is made of plastic.

13. An electronic component according to any preceding claim, wherein the electronic component comprises a cap on the second side of the substrate.
